(19) Europäisches Patentamt
European Patent Office
Office européen des brevets

(11) Veröffentlichungsnummer: **0 270 024 B1**

# (12) EUROPÄISCHE PATENTSCHRIFT

(45) Veröffentlichungstag der Patentschrift: **13.05.92**

(51) Int. Cl.5: **C23C 14/18**, C23C 14/38, C23C 14/44, C03C 17/22

(21) Anmeldenummer: **87117565.9**

(22) Anmeldetag: **27.11.87**

## (54) Hartstoffkompositschichten auf silikatischen Substraten und Verfahren zu ihrer Herstellung.

(30) Priorität: **01.12.86 DD 296883**

(43) Veröffentlichungstag der Anmeldung: **08.06.88 Patentblatt 88/23**

(45) Bekanntmachung des Hinweises auf die Patenterteilung: **13.05.92 Patentblatt 92/20**

(84) Benannte Vertragsstaaten: **AT BE DE FR NL SE**

(56) Entgegenhaltungen:
**AT-B- 380 700**
**DE-A- 1 521 157**
**DE-A- 2 153 861**
**DE-C- 3 144 192**

(73) Patentinhaber: **Flachglas Torgau GmbH**
**Repitzer Weg**
**O-7290 Torgau(DE)**

(72) Erfinder: **Schicht, Heinz, Dr.**
**Nr. 72**
**O-7901 Bethau(DE)**
Erfinder: **Kaiser, Wilfried**
**Strasse des Friedens 52**
**O-7290 Torgau(DE)**
Erfinder: **Krüger, Manfred, Dr.**
**Eilenburger Strasse 38**
**O-7290 Torgau(DE)**
Erfinder: **Becker, Hans-Joachim, Dr.**
**Bärwinkelstrasse 23**
**O-7290 Torgau(DE)**
Erfinder: **Schiller, Siegfried, Prof. Dr.**
**Plattleite 17**
**O-8051 Dresden(DE)**
Erfinder: **Beister, Günter, Dr.**
**Siedlungsstrasse 4**
**O-8056 Dresden(DE)**
Erfinder: **Hoffmann, Bernd**
**Nr. 6a**
**O-8261 Lossen(DE)**
Erfinder: **Finster, Joachim, Dr.**
**Wachauer Strasse 9**
**O-7027 Leipzig(DE)**
Erfinder: **Meisel, Armin, Prof. Dr.**
**Kommandant-Trufanow-Strasse 33**
**O-7022 Leipzig(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 270 024 B1

(74) Vertreter: **Biermann, Wilhelm, Dr.-Ing.**
**VEGLA Vereinigte Glaswerke GmbH Viktoriaallee 3-5**
**W-5100 Aachen(DE)**

**Beschreibung**

Die Erfindung betrifft Hartstoffkompositschichten auf silikatischen Substraten, insbesondere auf Glas, die tribologisch und chemisch äußerst widerstandsfähig sind und verschiedenen funktionellen und dekorativen Zwecken genügen, und ein Verfahren zur Herstellung von Hartstoffkompositschichten; diese Hartstoffkompositschichten verleihen beispielsweise Kippdächern aus Glas im Dachbereich von Kraftfahrzeugen bestimmte Farbtönungen und energetische Eigenschaften, dienen der Herstellung von Plotterscheiben mit Leiterzügen bestimmter elektrischer Werte oder von Spiegeln sowie beispielsweise der Veredlung von Haushaltsgläsern, Weihnachtsbaumschmuck und keramischen Fliesen.

Es ist bekannt, daß durch Aufbringen dünner Überzüge von Nitriden oder Karbiden der Elemente Silizium, Bor oder den Übergangsmetallen der IV., V. und VI. Nebengruppe des Periodensystems der Elemente auf Metall-, Plast- oder Glassubstrate mittels physikalischer oder chemischer Auftragstechniken eine Reihe neuer Anwendungen funktioneller und dekorativer Art erschlossen wurden. Den mit physikalischen Auftragstechniken abgeschiedenen Titannitridhartstoffschichten ($TiN_x$-Schichten) kommt dabei eine besondere Bedeutung zu, da mit ihnen neben dekorativen Effekten (z.B. Farbtöne in Grau, Silber, Graugold oder Gold) ausgezeichnete tribologische (Härte und Abrieb) und chemische Eigenschaften (Beständigkeit gegenüber aggresiven Medien) in Abhängigkeit vom Nitrierungsgrad x erreichbar sind. Dabei handelt es sich um umweltfreundliche Beschichtungstechnologien mit hoher Reproduzierbarkeit der Erzeugniseigenschaften für eine breite Substratpalette aufgrund der relativ niedrigen Substrattemperaturen beim Beschichten von 200 - 500 °C gegenüber den Substrattemperaturen bei chemischen Auftragstechniken von 900 -1100°C nach Münz, W.D.; Hofmann, D.: Metalloberfläche 37 (1983) S. 279 - 284. Trotz dieser Vorteile der physikalischen Auftragstechniken bereitet die Beschichtung von nichtmetallischen Substraten insbesondere hinsichtlich des Erreichens notwendiger Härten und Abriebfestigkeiten der $TiN_x$-Schichten erhebliche Probleme, da u.a. die hierfür notwendigen Substrattemperaturen von 200 - 500°C oftmals nicht bzw. nur eingeschränkt anwendbar sind.

Auch eine auf die tribologischen Eigenschaften der $TiN_x$-Schichten günstig wirkende negative Substratvorspannung (Substratbeschuß mit positiven Ionen) kann bei silikatischen Materialien wie Glas und Keramik nicht angewendet werden. Derartige Schichten besitzen dann eine zu geringe Haftfestigkeit und zwangsläufig eine damit im Zusammenhang stehende mangelhafte Abriebfestigkeit (vergleiche hierzu Pulker, H.K.: Appl. Optics 18 (1979) 12, S. 1969 - 1976).

Um diese Mängel einzuschränken, werden vor allem Glassubstrate mit anderen Schichten wie z. B. aus $Cr_xN_y$, binären Cr/Ni- oder Al/Ni-Legierungen vorbeschichtet, um damit Einfluß auf die Struktur und der damit im Zusammenhang stehenden tribologischen Eigenschaften der $TiN_x$-Schichten nehmen zu können. Eine derartige Lösung ist jedoch technologisch aufwendig und bewirkt, daß oftmals der gewünschte Farbton der $TiN_x$-Schichten auf der unbeschichteten Glasseite nicht sichtbar ist bzw. verfälscht wird.

Es ist weiterhin möglich, $TiN_x$-Schichten mit den gewünschten tribologischen und chemischen Eigenschaften durch reaktive Umsetzung auf einem Metallsubstrat abzuscheiden und dieses dann in einem zweiten, andersgearteten Prozeßschritt als Target für die Glasbeschichtung u. dgl. einzusetzen (DE-A-21 53 861). Die Nachteile dieser Beschichtung liegen in dem zu hohen technischen Aufwand der Zweistufentechnologie und der zu geringen Produktivität.

Mit dem Aufbringen von $TiN_x$-Mehrfachschichten, wobei sich zwei benachbarte Schichten im Nitrierungsgrad x unterscheiden, werden bei metallischen Substraten zwar hohe Beständigkeiten gegenüber Reibung, Korrosion usw. erzielt, bei silikatischen Substraten können die bekannten Mängel trotz eines erhöhten technologischen Aufwandes nicht beseitigt werden (FR-A-2 483 848).

In der DE-A-15 21 157 werden Mehrfachschichten aus $TiO_2$ und $TiN_x$ auf Glassubstraten mit alternierendem Aufbau beschrieben, wobei beim Übergang von einer Schicht zur anderen der Wechsel der Aufdampfatmosphäre nicht abrupt, sondern allmählich erfolgt. Durch einen derartigen Schichtaufbau wird die Haftung zwischen den Schichten und dem Substrat verbessert. Der Nachteil ist ein relativ aufwendiger apparativer Aufbau durch den erforderlichen sukzessiven Gaswechsel.

Auch das sukzessive Erhöhen des Stickstoffpartialdruckes

$$p_{N_2}$$

während der Beschichtung ist technisch aufwendig und nicht für jede Verfahrensgestaltung anwendbar (DE-A-28 42 393).

Ferner ist bekannt, die tribologischen Eigenschaften von $TiN_x$-Schichten durch den Einbau von Kohlenstoff und Sauerstoff zu Kompositschichten des Typs $TiC_xN_y$ oder $TiC_xO_yN_z$ zu modifizieren, wobei das dekorative Aussehen (Farbe) gegenüber den $TiN_x$-Schichten weitestgehend konstant gehalten werden kann und derartige Kompositschichten echte homogene chemische Verbindungen darstellen, wie es von Fark, H. u.a.: Thin Solid Films (1983) 3, S. 193 - 201 diskutiert wird. Angewendet werden derartige Kompositschichten nur für Metallsubstratbeschichtungen (DE-C-31 44 192). Bei der Beschichtung von Glas oder anderen silikatischen Materialien werden gegenüber der reinen $TiN_x$-Beschichtung keine verbesserten Eigenschaften erzielt.

Der Erfindung liegt die Aufgabe zugrunde, auf technologisch einfache und kostengünstige Weise Hartstoffkompositschichten für die Beschichtung von Glas und anderen silikatischen Substraten zu schaffen, die eine sehr gute Haftung zum Substrat, eine hohe Abriebfestigkeit und Härte sowie eine sehr gute Resistenz gegenüber Handschweiß und chemischen Agenzien haben sollen und verschiedene Reflexions- und/oder Transmissionsfarben aufweisen und damit in dekorativer und funktioneller Hinsicht verschiedenen Anforderungen genügen.

Es wurde überraschenderweise gefunden, daß die Aufgabe dann gelöst wird, wenn Hartstoffkompositschichten, die aus diskreten Bereichen der Einzelkomponenten
$TiN_{0,3...1,1}.TiO_{2,0...1,5}.TiCO_{1,0...3,0}$ bestehen, aufgebracht werden. Dabei hat es sich als vorteilhaft erwiesen, wenn die diskreten Bereiche der Einzelkomponenten der Hartstoffkompositschichten eine Größe von 20...30 nm haben.

Die Herstellung der erfindungsgemäßen Hartstoffkompositschichten erfolgt mit einem Verfahren, bei welchem sie durch reaktives Gleichstrom-Hochratezerstäuben eines Ti-Targets in einer Argon-Stickstoff-Sauerstoff-Kohlenwasserstoff-Arbeitsgasatmosphäre im Vakuum aufgebracht werden, und daß nach Herstellung des Hochvakuums im verbliebenen Restgas ein Gehalt an Sauerstof $O_2$ und Kohlenwasserstoffen KW in einem Verhältnis der relativen Massenzahlen von $O_2$:KW $\geqq$ 7,0 eingestellt wird, der bei der anschließenden Herstellung der Arbeitsgasatmosphäre beibehalten wird. Die Einstellung des Verhältnisses $O_2$:KW erfolgt beim KW-Anteil über das Treibmittel im Restgas durch dampfdruckreduzierende Maßnahmen und beim $O_2$-Anteil durch Lufteinlaß über ein Nadelventil.

Liegt das Verhältnis $O_2$:KW bei < 7,0 so zeigen die Schichten ein schlechtes Abriebverhalten, sind handschweißempfindlich und für die vorgesehenen Verwendungszwecke unbrauchbar. In solchen Schichten läßt sich verstärkt Titancarbid (TiC) nachweisen.

Im folgenden wird die Erfindung anhand der Beschichtung von Gläsern zur Verwendung als Kraftfahrzeugkippdächer und Spiegel näher beschrieben und werden die erfindungsgemäßen vorteilhaften Wirkungen aufgezeigt.

Die für die Beschichtung vorgesehenen Substrate werden zunächst in einem mehrstufigen Ultraschallbad gründlich gereinigt und durchlaufen auf einer Palette liegend eine Mehrkammer-Vakuumanlage. Es handelt sich um eine modifizierte Anlage des Typs HZS-02, die mit Magnetrons vom Typ Planar-Plasmatron PPS 25/610 mm bestückt ist. In den fünf Kammern laufen folgende technologische Prozesse ab bzw. haben sie folgende Funktionen:

- Kammer 1: Eingangsschleuse
- Kammer 2: Glimmbehandlung der Substrate bei 2,5 kV; 2 A; 50 - 60 s in Ar
- Kammer 3/4: Beschichtung der Substrate
- Kammer 5: Ausgangsschleuse

Beispiel 1

Leicht gewölbte Einscheibensicherheitsgläser für Kraftfahrzeugkippdächer der Abmessungen 450 mm x 750 mm werden nach der oben genannten Vorbehandlung in der beschriebenen Durchlaufanlage mit Hilfe des reaktiven Gleichstrom-Hochratezerstäubens eines Ti-Targets in einer Argon-Stickstoff-Sauerstoff-Kohlenwasserstoff-Arbeitsgasatmosphäre unter folgenden Bedingungen beschichtet:

| | |
|---|---|
| - Plasmatronleistung: | 20 kW |
| - Druck vor der Arbeitsgasbildung bei geöffnetem Nadelventil: | $\sim 1,3.10^{-2}$ Pa |
| - $Ar/N_2$-Druck während des Zerstäubens: | $\sim 5.10^{-1}$ Pa |
| - Einstellwert der Plasmastrahlungsintensität ($\lambda$ = 466 nm) als Maß für den $N_2$-Partialdruck im Arbeitsgas: | 80 Skaltenteile (Hellwert = 100 Skalenteile) |
| - Palettentransportgeschwindigkeit: | 40 mm/s |

Das relative Verhältnis der Massenzahlen von Sauerstoff:Kohlenwasserstoffen ($O_2$ : KW) im Restgas des Hochvakuumbereiches vor der Arbeitsgasbildung betrug 9,2 (bezogen auf $N_2$ = 1, ermittelt mit einem Massenspektrometer Monopol MX 7303 bekannter sowjetischer Bauart). Der entsprechende $O_2$-Gehalt im Arbeitsgas wurde mittels Luft über ein Nadelventil eingestellt. Der KW-Anteil wirde mit Flüssigstickstoff-Buffels über den Diffusionspumpen, durch Kühlung der Öldampfsperren mit einem Kühlaggregat sowie gegen die Vorpumpen gerichtete Luft- und Ar-Strömungen minimiert.

An den auf diese Weise beschichteten Gläsern für Kraftfahrzeugkippdächer wurden folgende Parameter bzw. Eigenschaften ermittelt:

- Kompositschichtzusammensetzung, gemessen mit einem Gerät Vacuum Generators ESCA 3 der englischen Firma Taylor-Hobson ($AlK_{\alpha}$ -Anregung, Vakuum besser als $10^{-6}$ Pa) : $TiN_{\sim 1,0} \cdot TiO_{\sim 1,5} \cdot TiCO_{1,0 \ldots 3,0}$ . Die Schichten enthielten kein TiC.
- Größe der diskreten Bereiche der Einzelkomponenten der Hartstoffkompositschicht im Mittel, gemessen über Elektronentransmission mit einer Anlage EF-Z6 des VEB Carl Zeiss Jena: 20 - 30 nm
- Lichttransmission (bei $\lambda$= 585 nm): 10 % ($\hat{=}$ 50 nm Schichtdicke)
- Energietransmission: 9 %
- Reflexionsfarbe: hellgold

- Transmissionsfarbe: hellblau
- Schwitzwasserversuch nach DIN 50017: 480 h ohne Defekte
- Prüfung der Haftfestigkeit durch Kochen nach DIN 58196/Teil 2: ohne Defekte
- Pilling-Test: ohne Defekte
  Die Prüfung der Wischfestigkeit mit dem Pilling-Test erfolgt mit ≥ 3000 Hüben bei gleichzeitiger Rotation eines mit einem Baumwolltuch, angefeuchtet mit Fensterputzmittel, bespannten Prüfkopfes bei einem konstanten Anpreßdruck von 30 $p.cm^{-2}$.
- Schwingungstest: ohne Defekte
  Um den Abrieb bei Schwingungen und Vibrationen im realen Fahrbetrieb und die Belastungen beim Transport von Kippdächern besser zu simulieren, wurde der sogn. Schwingungstest entwickelt. Die Schicht wird an einem feststehenden Prüfling über 90 min mit einem 7 Hz und einer Amplitude von ca. 1 mm schwingenden Polychloropren-Moosgummi-Körper bei konstantem Anpreßdruck getestet.

Die erfindungsgemäß beschichteten Gläser für Kraftfahrzeugkippdächer sind gegen Handschweiß und übliche Reinigungsmittel resistent sowie abriebfest in üblichen Verpackungseinheiten (z.B. Kisten) und bei Kontakt mit dem Abdichtgummi des Rahmens während des Fahrbetriebes. Die Beschichtung verleiht der Kippdachscheibe aus Glas ein eindrucksvolles, dekoratives Aussehen.

Im Vergleich wurden analoge Gläser ultraschallgereinigt, glimmbehandelt, jedoch bei anderen Arbeitsgasverhältnissen mit folgenden Ergebnissen beschichtet:

| | |
|---|---|
| - Schichtzusammensetzung: | $TiN_{\sim 1,0} \cdot TiO_{\sim 1,5} \cdot TiCO_{1,0...3,0} \cdot TiC$ |
| - Lichttransmission: | 10 % (≙ 50 nm Schichtdicke) |
| - Energietransmission: | 9 % |
| - Reflexionsfarbe: | hellgold |
| - Transmissionsfarbe: | hellblau |
| - Schwitzwasserverbrauch nach DIN 50017 : | 480 h ohne Defekte |
| - Prüfung der Haftfestigkeit nach DIN 58196/Teil 2: | ohne Defekte |
| -Pilling-Test: | bei ca. 1000-2000 Hüben erste Defekte |
| - Schwingungstest: | nach < 90 min Defekte |

Diese Gläser erfüllen die an sie gestellten Forderungen bezüglich Resistenz gegenüber Handschweiß und üblichen Reinigungsmitteln und Abrieb nicht.

Beispiel 2

Eine 10 cm x 10 cm große Floatglasprobe wird analog Beispiel 1 behandelt und beschichtet, lediglich die Palettentransportgeschwindigkeit wird auf 20 mm/s verringert.

Folgende Parameter und Eigenschaften wurden ermittelt:

- Kompositschichtzusammensetzung (gemessen wie Beispiel 1) : $TiN_{\sim 1,0} \cdot TiO_{\sim 1,5} \cdot TiCO_{1.0...3,0}$
- Größe der diskreten Bereiche der Einzelkomponeten der Hartstoffkompositschichten (gemessen wie Beispiel 1) : 20 - 30 nm
- Lichttransmission: 0 (≙ Schichtdicke > 100 nm)
- Reflexionsfarbe: gold

  Reflexionsgrad (gemessen mit einem Spektralfotometer ACTA M4 der Firma Beckmann, BRD): ≥ 0,50 (Schichtseite)
- Schwitzwasserversuch nach DIN 50017: 480 h ohne Defekte
- Salzsprühnebeltest nach DIN 50021: 780 h ohne Defekte
- Cass-Test nach DIN 50021: 120 h ohne Defekte
- Pilling-Test (gemessen wie Beispiel 1): ohne Defekte

Bei einem derartigen Spiegel mit diesen hervorragenden tribologischen und chemischen-Eigenschaften kann von einer ungewöhnlich langen Lebensdauer ausgegangen werden; beispielsweise kann ein Rückflächenspiegel ohne zusätzlichen Lackschutz eingesetzt werden.

Beispiel 3

Kraftfahrzeugspiegelrohlinge (gebogenes und/oder kantenbearbeitetes Flachglas) werden analog dem Beispiel 1 behandelt, die Beschichtung erfolgt jedoch unter folgenden geänderten Bedingungen:

- $Ar/N_2$-Druck während des Zerstäubens: $\sim 6.10^{-1}$ Pa
- Einstellwert der Plasmastrahlungsintensität ($\lambda$ = 466 nm) als Maß für den $N_2$-Partialdruck im Arbeitsgas: 90 Skalenteile (Hellwert = 100 Skalenteile)
- Palettentransportgeschwindigkeit: 20 mm/s

Folgende Parameter und Eigenschaften wurden ermittelt:

- Kompositschichtzusammensetzung (gemessen wie Beispiel 1): $TiN_{\sim 0,3} \cdot TiO_{\sim 2,0} \cdot TiCO_{1,0...3,0}$
- Größe der diskreten Bereiche der Einzelkomponenten des Hartstoffkompositschichtsystems (gemessen wie Beispiel 1): 20 - 30 nm
- Lichttransmission: 0 ($\hat{=}$ Gesamtschichtdicke >100 nm)
- Reflexionsfarbe: silbergrau
- Reflexionsgrad (gemessen wie Beispiel 2): $\geq$ 0,45 (Schichtseite)

| | |
|---|---|
| - Schwitzwasserversuch (gemessen wie Beispiel 2): | 480 h ohne Defekte |
| - Salzsprühnebeltest (gemessen wie Beispiel 2): | 780 h ohne Defekte |
| - Cass-Test (gemessen wie Beispiel 2): | 120 h ohne Defekte |
| - Pilling-Test:(gemessen wie Beispiel 1): | ohne Defekte |

Derartige KfZ-Spiegel können als reflexgeminderte Oberflächen- oder als Rückflächenspiegel ohne Lackschutz verwendet werden. Sie erfüllen alle an sie gestellten nationalen und internationalen Normen bezüglich der Beständigkeit und besitzen eine sehr hohe Lebensdauer.
Die erfindungsgemäßen Hartstoffkompositschichten mit ihren außergewöhnlich guten tribologischen und chemischen Eigenschaften können auch auf Fliesen, Haushalts- und Vitrinengläsern, auf Weihnachtsbaumschmuck usw. zwecks Erzielung dekorativer bzw. farbiger Effekte abgeschieden werden.

**Patentansprüche**

1. Hartstoffkompositschichten auf silikatischen Substraten, insbesondere auf Glas, die tribologisch und chemisch äußerst widerstandsfähig sind und verschiedenen funktionellen und dekorativen Zwecken genügen, **dadurch gekennzeichnet,** daß sie aus diskreten Bereichen der Einzelkomponenten $TiN_{0,3\text{-}1.1}$ . $TiO_{2,0\text{-}1,5}$ . $TiCO_{1,0\text{-}3,0}$ bestehen.

2. Hartstoffkompositschichten nach Anspruch 1, **dadurch gekennzeichnet,** daß die diskreten Bereiche der Einzelkomponenten eine Größe von 20-30nm haben.

3. Verfahren zur Herstellung von Hartstoffkompositschichten nach Anspruch 1 oder 2, **dadurch gekennzeichnet,** daß sie durch reaktives Gleichstrom-Hochratezerstäuben eines Ti-Targets in einer Argon-Stickstoff-Sauerstoff-Kohlenwasserstoff-Arbeitsgasatmosphäre im Vakuum aufgebracht werden, und daß nach Herstellung des Hochvakuums im verbliebenen Restgas ein Gehalt an Sauerstoff $O_2$ und Kohlenwasserstoffen KW in einem Verhältnis der relativen Massenzahlen von $O_2$:KW ≧ 7,0 eingestellt wird, der bei der anschließenden Herstellung der Arbeitsgasatmosphäre beibehalten wird.

**Claims**

1. Hard material composite layers of silicate substrates, especially of glass, which are tribologically and chemically extremely resistant and fulfill diverse functions and decorative purposes, characterised thereby that they consist of discrete regions of the individual components $TiN_{0,3\text{-}1,1}$ . $TiO_{2,0\text{-}1,5}$ . $TiCO_{1,0\text{-}3,0}$ .

2. Hard material composite layers according to claim 1, characterised thereby that the discrete regions of the individual components have a size of 20 to 30 nm.

3. Process for the manufacture of hard material composite layers according to claim 1 or 2, characterised thereby that they are applied by reactive direct-current high-rate spraying of a Ti target in an argon-nitrogen-oxygen-hydrocarbon working gas atmosphere in a vacuum, and that after the production of the high vacuum an oxygen $O_2$ and hydrocarbon KW content in a ratio of the relative mass numbers of $O_2$ : KW being equal to or greater than 7.0, which is maintained in the subsequent production of the working gas atmosphere, is set in the remaining residual gas.

## Revendications

1. Couches composites de matière dure sur des substrats de silicate, en particulier de verre, qui sont tribologiquement et chimiquement résistantes au plus haut degré et conviennent à diverses fins fonctionnelles et décoratives, caractérisées en ce qu'elles consistent en régions discrètes des composants particuliers $TiN_{0,3-1,1}.TiO_{2,0-1,5}.TiCO_{1,0-3,0}$.

2. Couches composites de matière dure suivant la revendication 1, caractérisées en ce que les régions discrètes des composants particuliers ont une dimension de 20 - 30 nm.

3. Procédé de fabrication de couches composites de matière dure suivant la revendication 1 ou 2, caractérisé en ce qu'elles sont appliquées sous vide par pulvérisation réactive à haute intensité en courant continu d'une cible de Ti dans une atmosphère de travail d'argon-azote-oxygène-hydrocarbures et en ce qu'après l'établissement du haut vide dans le gaz résiduel restant, les teneurs en oxygène $O_2$ et en hydrocarbures HC sont ajustées dans un rapport des nombres de masse relatifs de $O_2:HC \geqq 7,0$, qui est maintenu lors de la constitution ultérieure de l'atmosphère de travail.